# EUROPEAN PATENT SPECIFICATION

(11) **EP 2 463 674 B1**
(45) Date of publication and mention of the grant of the patent: **03.07.2013**
(21) Application number: 10194175.5
(22) Date of filing: 08.12.2010
(51) Int. Cl.: G01R 31/34, G01R 27/32, G05F 1/67, H02P 9/00, F03D 7/00, F03D 7/02

(54) **Arrangement and method for testing an electric power generation system**
Anordnung und Verfahren zum Prüfen eines Stromerzeugungssystems
Agencement et procédé de test d'un système de génération d'alimentation électrique

(43) Date of publication of application: 13.06.2012
(73) Proprietor: Siemens Aktiengesellschaft, 80333 München (DE)
(72) Inventor: Dreyer, Thomas, 28832, Achim (DE); Wulff, Steffen, 28217, Bremen (DE)

(56) References cited:
- EP-A2- 1 801 414
- EP-A2- 2 072 813
- EP-A2- 2 141 788
- WO-A1-2007/140789
- WO-A1-2008/109264
- US-A- 5 798 632
- US-A- 6 111 767
- US-A1- 2003 227 172
- US-A1- 2007 241 759
- US-A1- 2010 010 684

## Description

### Field of invention

The present invention relates to an arrangement and to a method for testing an electric power generation system, in particular a wind turbine system, connected to an utility grid for testing the electric power generation system when an overvoltage occurs at the utility grid.

### Art Background

An electric power generation system, in particular a wind turbine system, supposed to be connected to an utility grid may be required to satisfy particular electrical properties and a particular electrical behaviour when subjected to different electrical situations. In particular, it may be necessary for the electric power generation system to withstand a voltage drop occurring at the utility grid.

It has however been observed that situations other than a voltage drop may occur at the utility grid. In particular, the utility grid may under certain load conditions or energy supply conditions provide a voltage at a grid terminal via which the electric power generation system is connected to the utility grid, wherein the provided voltage is higher than a predetermined operation voltage of the utility grid. Thereby, the operation of the electric power generation system may be deteriorated or in the worst case the electric power generation system may be damaged or even destroyed.

Document EP 2 072 813 A2 discloses a control system and method for operating a wind farm, wherein wind turbines are connected via an internal grid with a transformer substation using feeders. Thereby, the power produced by the wind turbines may be stepped-up in voltage by turbine transformers before being coupled to the internal grid. A station transformer of the transformer substation is used to step-up voltage from the internal grid voltage to a required transmission voltage to the external, main or utility grid, to which the transformer substation can be connected at the point of common coupling using a suitable power switch.

Document WO 2007/140789 A1 discloses a wind turbine testing system for testing at least a part of the nacelle components of a wind turbine system, when mounted on a load-carrying structure of a nacelle, wherein the wind turbine testing system comprises a test bench being arranged to hold said load-carrying structure including said nacelle components, a grid simulation system comprising a power converter system and a simulation controller being arranged to be electrically coupled to at least one of said nacelle components and being adapted for providing a simulated utility grid on the basis of a power supply.

Document US 5,798,632 discloses a variable speed wind turbine generator with zero-sequence filter, including an excitation controller, a RPM-converter, a zero-sequence filter and a transformer.

Document EP 2 141 788 A2 discloses optimizing converter protection for wind turbine generators.

Document US 6,111,767 discloses an inverter integrated instrumentation having a current-voltage curve tracer, wherein a transformer connects to a utility grid.

Document WO 2008/109264 A1 discloses control of combined storage and generation in distributed energy resources, wherein each active component of the distribution system reacts to local information, such as a voltage, a current, and a frequency to change its operating point.

Document EP 1 801 414 A2 discloses a system and method for testing a wind turbine, wherein the wind turbine is tested by using a point of interaction (PCI) substation before supplying the wind turbine to a customer.

There may be a need for an arrangement and for a method for testing an electric power generation system, in particular a wind turbine system, connected to an utility grid, wherein the arrangement for testing is improved compared to a conventional test equipment.

### Summary of the Invention

This need may be met by the subject matter according to the independent claims. Advantageous embodiments of the present invention are described by the dependent claims.

According to an embodiment an arrangement (in particular comprising one or more electric or electronic components including wire connections) for testing (in particular examining or analyzing an electric behaviour or an electric property of the electric power generation system) an electric power generation system (a system designed for generating electric power by supplying electric voltage and/or electric current to one or more output terminals of the electric power generation system), in particular a wind turbine system (in particular comprising a wind turbine tower, a nacelle mounted on top of the wind turbine tower, a rotor shaft rotatably supported within the nacelle and having fixed thereon one or more rotor blades, and an electrical generator mechanically connected to the rotation shaft for generating an electric current and/or an electric voltage, i.e. a power signal, upon rotation of the rotation shaft at one or more output terminals of the wind turbine system, the electric power in particular being provided via an alternating electric power signal having a variable frequency in accordance with a rotational speed of the rotation shaft) , being connected to an utility grid (being in particular a power network on one hand connected to one or more electric power generation systems that supply electric energy to the utility grid and being on the other hand connected to one or more consumers or loads consuming the electric power supplied by the electric power generation systems, wherein the utility grid may be operated at a particular predetermined frequency, such as 50 Hz or 60 Hz, and wherein the utility grid may operate at a predetermined operation voltage or predetermined first voltage which may amount to between 10 kV and 50 kV depending on the local regulations providing a predetermined first voltage (in particular at a grid supply terminal for supplying electric energy, in particular an electric power signal, from the electric power generation system), wherein the arrangement comprises an input terminal (in particular comprising one or more input terminals for each electrical phase, such as two phases, three phases, or even more phases) for connecting the arrangement to an output terminal (where the electric power signal is output) of the power generation system; a grid terminal (in particular comprising one or more grid terminals for each phase the grid is operating in, such as two phases, three phases or even more phases) for connecting the arrangement to the utility grid; a transformer (an electric device that transfers electrical energy from one circuit to another through inductively coupled conductors, wherein a varying current in the first or primary winding may create a varying magnetic flux in the transformer's core and thus a varying magnetic field through the secondary winding, wherein at terminals of the secondary winding the transformed voltage being higher or lower than the input voltage is applied) temporarily (in particular during short time intervals, such as a time interval between 0.1 ms and 1 s) connectable (in particular via one or more switches which may in particular be controlled by a control system) between the input terminal and the grid terminal (which still allows that one or more other electric or electronic components are arranged on one hand between the grid terminal and the transformer and on the other hand between the transformer and the input terminal), wherein the transformer is adapted to transform the first voltage (in particular the operation voltage of the utility grid) to a second voltage which is different from the first voltage (wherein in particular a frequency of the first voltage equals the frequency of the second voltage, wherein in particular the second voltage is higher than the first voltage); and a measurement system (in particular comprising one or more current sensors and/or one or more voltage sensors) for measuring a current flow through the input terminal (in particular through a wire leading through the input terminal).

Thereby, it is enabled to examine, to analyze or to test a behavior of an electric power generation system, when the electric power generation system is subjected to an overvoltage at its output terminal (or at its output terminals). Further, it is enabled to generate the overvoltage using the test arrangement by connecting the test arrangement between the utility grid and the electric power generation system, by adjusting a transformation ratio of the transformer appropriately and connecting the adjusted transformer between the input terminal (which is connected to the electric power generation system) and the grid terminal (which is connected to the utility grid). In particular, the measurement system may be adapted to measure a current flow at a number of locations within the arrangement for testing the electric power generation system, wherein measurement of the current flow at these locations is indicative of the electrical behavior of the electric power generation system.

Thus, the test arrangement is adapted to examine or test the behaviour of the electric power generation system in case of an overvoltage applied at a grid terminal of the utility grid, wherein the electric power generation system is subjected to a higher voltage than the electric power generation system is configured to operate in a normal condition.

According to an embodiment the second voltage is greater than the first voltage by an amount between 5% and 100%, in particular between 10% and 70%, further in particular between 30% and 50%, of the first voltage. Thus, typical overvoltages currently occurring at an utility grid may be simulated using the test arrangement. Thereby the electric power generation system may be subjected to overvoltages actually frequently occurring in current utility grids. According to other embodiments the second voltage may be even larger than 100% of the first voltage.

According to an embodiment the transformer is configured (in particular by providing a primary winding, by providing a secondary winding inductively coupled to the primary winding and adjusting or selecting a number of turns in the primary winding and a number of turns in the secondary winding, thereby in particular adjusting or configuring a ratio of the number of turns in the secondary coil relative to the number of turns in the primary coil) such that a ratio between the first voltage and the second voltage may be variably adjusted, in particular to a ratio between 1:1 and 1:1.5. Thereby, the second voltage may be generated in a simple manner by appropriately adjusting a ratio of the number of turns in the secondary winding relative to the number of turns in the primary winding of the transformer and/or by providing one or more tapping connections at the secondary winding.

According to an embodiment the transformer comprises a tapped transformer. Thereby a tapped transformer may be characterized by one or more connection nodes or connection points along a winding of the transformer, in particular along the secondary winding of the transformer, wherein at the one or more connection points voltages transformed at different transformation ratios may be received. By receiving the transformed voltage at a particular connection point the second voltage may be variably adjusted. In other embodiments another type of transformer may be used, in particular for example comprising more than one secondary windings, the secondary windings having different numbers of turns. To adjust the second voltage one or more switches may be employed for setting the connections to the tapped transformer appropriately.

According to an embodiment the test arrangement further comprises an electric control system (for example comprising a data processing system, a computer, one or more relays and signal or control lines for connecting the electric control system to one or more components of the test arrangement, such as the transformer, switches in the test arrangement and/or one or more coils) adapted to maintain the second voltage for a predetermined time interval of between 0.1 ms and 1 s, in particular of between 1 ms and 50 ms.

In particular, the control system may be adapted to perform a sequence of actions such as switching actions to configure the transformator, to actuate a voltage dropping system for dropping the voltage at the input terminal, to connect the transformator between the grid terminal and the input terminal and to deactivate the voltage dropping system such that the overvoltage, in particular the second voltage is applied to the input terminal. The predetermined time interval may depend on the particular application and on local regulations. In particular, the predetermined time interval may be selected such that a damage to the electric power generation system does not occur. Thereby, the testing procedure for testing the electric power generation system may be improved.

According to the invention the electric control system comprises a controllable switch (wherein opening and/or closing the controllable switch may be controlled, in particular by the electric control system) connected in parallel to the transformer. Thereby, the controllable switch may bypass the transformer when the controllable switch is closed. Thereby, the grid terminal may be directly connected (via the controllable switch) to the input terminal.

According to an embodiment the control system comprises a controllable series switch system connected in series with the transformer between the input terminal and the grid terminal to disconnect the transformer from the utility grid and/or from the input terminal. In particular, the controllable series switch system may comprise two series switches, one of which may be connected between the grid terminal and the transformer and the other of which may be connected between the transformer and the input terminal. In particular, when opening the controllable series switch system, in particular the two series switches, the transformer may be disconnected from the grid terminal and may also be disconnected from the input terminal. When at the same time the switch connected in parallel to the transformer is closed, the transformer will by bypassed such that the voltage at the grid terminal is fed to the input terminal. Thereby, controlling a voltage course for applying the overvoltage at the electric power generation system may be facilitated. In particular, when closing the controllable series switch system, in particular the two series switches, the transformer may be connected to the grid terminal and may also be connected to the input terminal. When at the same time the switch connected in parallel to the transformer is opened, the second voltage may be applied at the input terminal.

According to an embodiment the control system further comprises a first coil (or an inductor or in general a electrical component having an impedance being characterized by an imaginary resistance which increases with increasing frequency) connected between the input terminal and a reference node (which may in particular be connected to a ground potential or earth potential), in particular via at least one reference node switch. In particular, when the at least one reference node switch is closed a voltage at the input terminal may drop due to electric current flow through the first coil towards the reference node.

Thereby, controlling or regulating the voltage at the input terminal may be performed in a more flexible and simple way. In particular, the at least one reference node switch may comprise two series connected switches which are connected between the first coil and the reference node or which may be connected between the first coil and the input terminal. Alternatively, the at least one reference node switch may comprise two parallelly connected switches, wherein the parallelly connected switches are connected between the first coil and the reference node or the parallelly connected switches are connected between the first coil and the input node or input terminal. Thereby, it may be achieved to reduce the voltage at the input terminal according to a predetermined time course.

According to an embodiment the test arrangement may also be employed for generating a voltage drop at the input terminal via the current flow through the first coil. Further, the electrical behavior of the electric power generation system upon the generated voltage drop at the input terminal may be examined and analyzed.

According to an embodiment the measurement system is adapted for measuring a current flow at a point between the first coil and the reference node and/or at the grid terminal. Thereby, further parameters of the electric generation system may be acquired or measured. Thereby, the test arrangement may be improved.

According to an embodiment the control system further comprises a second coil (or inductor or impedance having a resistance increasing with increasing frequency) connected between the input terminal and a mid node, wherein the transformer is connected between the mid node and the grid terminal and wherein the control system in particular comprises a switch connected in parallel to the second coil. In particular, by closing the switch connected in parallel to the second coil the second coil may be bypassed. In particular, the second coil may limit a voltage drop at the input terminal such that a voltage drop smaller than the voltage drop at the input terminal is applied to the grid terminal.

According to an embodiment the measurement system is further adapted for measuring a voltage between a fixed potential node and the input terminal and/or the grid terminal. Thereby, the behavior of the electric power generation system may more thoroughly be analyzed. Further, the measurement system may be adapted to measure voltages at even more locations with respect to a fixed potential node (such as a ground potential or earth potential).

It should be noted that features (individually or in any combination) disclosed, described, explained or mentioned with respect to an arrangement for testing an electric power generation system may individually or in any combination also applied to a method for testing an electric power generation system and vice versa.

According to an embodiment a method for testing an electric power generation system, in particular a wind turbine system, being connected to an utility grid is provided, wherein the method comprises connecting (in particular electrically connecting or electrically coupling) the arrangement, via an input terminal, to an output terminal of the power generation system; connecting (in particular electrically connecting) the arrangement, via a grid terminal, to the utility grid providing a predetermined first voltage; transforming the first voltage to a second voltage which is different from the first voltage using a transformer connected between the input terminal and the grid terminal, and measuring a current flow through the input terminal using a measurement system.

In particular the measurement system may be adapted to examine the electric response of the electric power generation system upon applying the second voltage at the input terminal. The electric response of the electric power generation system may comprise an evolution (or time course) of a voltage at the input terminal, an evolution of a current flowing through the input terminal and/or a combination of the evolution of the current and the evolution of the voltage. Further, the measurement system may comprise a processing system for evaluating or processing the measured voltage and/or current values. For example, the measured current and/or voltage values may be compared to predetermined voltage and current criteria.

According to an embodiment the transforming the first voltage to the second voltage comprises disconnecting the transformer from the grid terminal (in particular by opening a series switch connected between the transformer and the grid terminal and further in particular by also opening a series switch connected between the transformer and the input terminal); adjusting (in particular comprising connecting an output terminal of the transformer to a particular connection point of a tapped transformer) a transformation ratio (which in particular defines a ratio of a voltage provided or output at the secondary winding relative to a voltage set or input at a primary winding of the transformer) of the transformer for transforming the first voltage to the second voltage (in particular during adjusting the transformation ratio the transformer is still disconnected from the grid terminal and in particular also disconnected from the input terminal); connecting the utility grid to the input terminal (in particular via a switch connected in parallel to the transformer, wherein the closed switch connected in parallel to the transformer bypasses the transformer such that the utility grid is connected via the bypass switch to the input terminal), reducing a voltage at the input terminal via a current flow via a first coil and a second coil towards a reference point (while the transformer is still disconnected from the grid terminal and is also still disconnected from the input terminal, wherein the electric power generation system is subjected to the reduced voltage at the input terminal, wherein the reduced voltage is lower than the first voltage); connecting the transformer to the grid terminal (and in particular also connecting the transformer to the second coil and in particular also opening the bypass switch parallelly connected to the transformer); and disconnecting the first coil from the reference node.

Thereby, the reducing the voltage at the input terminal is achieved by a current flow via a first coil which is connected between the grid terminal and the input terminal and via a second coil which is connected between the input terminal and a reference node towards a reference point (the current flow flows through the second coil and the first coil towards the reference node thereby causing a voltage drop at the input terminal).

Disconnecting the first coil from the reference node in particular abolishes the reducing of the voltage at the input terminal by the current flow through the second coil and the first coil. In particular, the disconnecting the first coil from the reference node may comprise opening at least one reference node switch connected between the first coil and the reference point or reference node or connected between the first coil and the input terminal. In particular disconnecting the first coil from the reference node may be performed in a faster way than connecting the transformer between the grid terminal and the input terminal. Thereby, an overvoltage may be applied at the input terminal for a shorter period of time by disconnecting the first coil from the reference node than by exclusively connecting the transformer between the grid terminal and the input terminal without using the first coil (and the second coil).

According to an embodiment the transforming the first voltage to the second voltage comprises applying the first voltage at the input terminal, while the transformer is connected to the grid terminal (and while the transformer is also connected to the second coil) and while the voltage at the input terminal is reduced by the current flow via the first coil and the second coil towards the reference point (thus, by reducing the voltage at the input terminal by the current flow via the second coil and the first coil the second voltage fed to the output terminal of the transformer is reduced such that the first voltage is applied at the input terminal); and applying the second voltage at the input terminal, while the first coil is disconnected from the reference node (thus disconnecting the first coil from the reference node abolishes the reduction of the voltage from the second voltage to the first voltage such that the second voltage generated by the transformer is applied at the input terminal).

According to other embodiments other sequences of switchings to disconnect or connect the transformer, the first coil and/or the second coil to the grid terminal, the input terminal and/or the reference node may be performed in a different way.

It has to be noted that embodiments of the invention have been described with reference to different subject matters. In particular, some embodiments have been described with reference to method type claims whereas other embodiments have been described with reference to apparatus type claims. However, a person skilled in the art will gather from the above and the following description that, unless other notified, in addition to any combination of features belonging to one type of subject matter also any combination between features relating to different subject matters, in particular between features of the method type claims and features of the apparatus type claims is considered as to be disclosed with this document.

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.

### Brief Description of the Drawings

Embodiments of the present invention are now described by reference to the accompanying drawings to which the invention is not limited.
Fig. 1 schematically illustrates an arrangement for testing an electric power generation system according to an embodiment;
Fig. 2 schematically illustrates a diagram of a time course of a voltage to which the electric power generation system illustrated in Fig. 1 is subjected using the arrangement for testing the electric power generation system illustrated in Fig. 1 or Fig. 3; and
Fig. 3 schematically illustrates an arrangement for testing an electric power generation system according to another embodiment.

### Detailed Description

The illustration in the drawing is schematic. It is noted that in different figures, similar or identical elements are provided with the same reference signs or with reference signs, which are different from the corresponding reference signs only within the first digit.

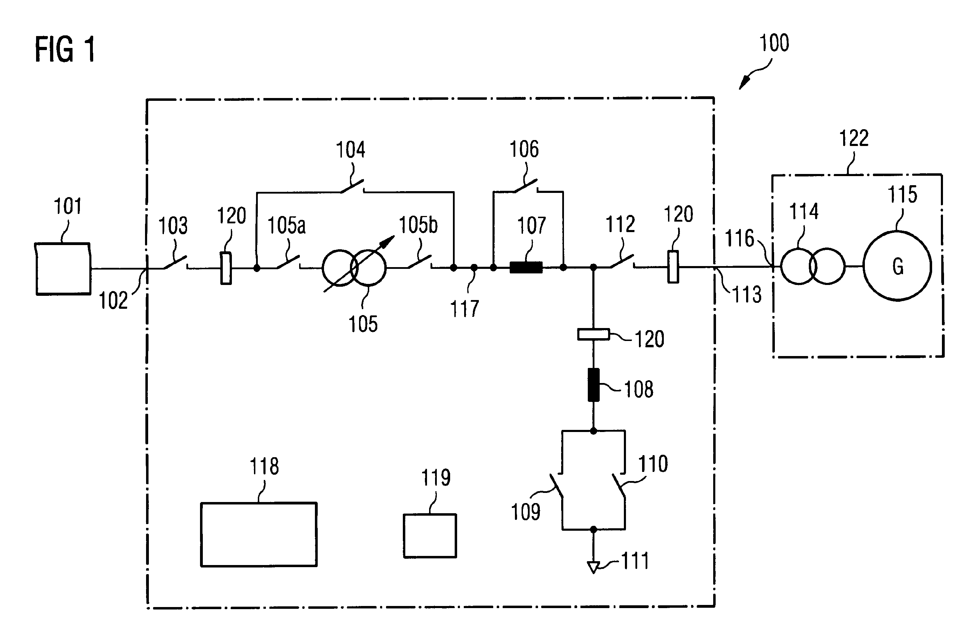

Fig. 1 schematically illustrates an arrangement 100 for testing an electric power generation system 115. The arrangement 100 for testing the electric power generation system (also referred to as test arrangement) comprises an input terminal 113 for connecting the arrangement 100 to an output terminal 116 of the power generation system 122 comprising the generating plant 115 and an optionally generating plant transformer 114. In other embodiments the generating plant 115 is directly connected to the input terminal 113 without having the transformer 114 interposed in between.

The test arrangement 100 further comprises a grid terminal 102 for connecting the arrangement 100 to the utility grid 101. In the illustrated embodiment the utility grid 101 provides a predetermined first voltage at the grid terminal 102. The test arrangement 100 is adapted for testing the power generation system 122 (114, 115) by supplying an overvoltage at the input terminal 113. The overvoltage (also referred to as second voltage) is larger than the first voltage at which the utility grid is designed to operate and which is applied at the grid terminal 102. A switch 103, a switch 105a, a transformer 105, a switch 105b, a coil or variable or fixed impedance 107 and a switch 112 are connected in series in this order between the grid terminal 102 and the input terminal 113.

In parallel to the transformer 105 a wire connection comprising a switch 104 is provided for bypassing the transformer 105, when the switch 104 is closed. Further, a bypass line is provided comprising a switch 106 for bypassing the coil 107, when the switch 106 is closed. Herein, the coil 107 is connected between the input terminal 113 and a mid point 117. The transformer 105 is connected between the mid point 117 and the grid point 102.

A coil or variable of fixed impedance 108 (also referred to as first coil) is connected between the switch 112 (leading to the input terminal 113) and a parallel arrangement of switches 109 and 110 which are connected to the reference node 111.

The test arrangement 100 further comprises a control system 118 for controlling opening and closing of the switches 103, 105a, 105b, 104, 106, 109, 110 and 112 and further for adjusting a transformation ratio of the transformer 105 via not illustrated control lines. The test arrangement 100 further comprises a measurement system 119 comprising measurement sensors 120 arranged at different locations within the test arrangement 100 for measuring an electric response of the electric power generation system 122 (114, 115) in response to an overvoltage applied at the input terminal 113. The measurement sensors 120 may comprise current measurement sensors and/or voltage measuring sensors.

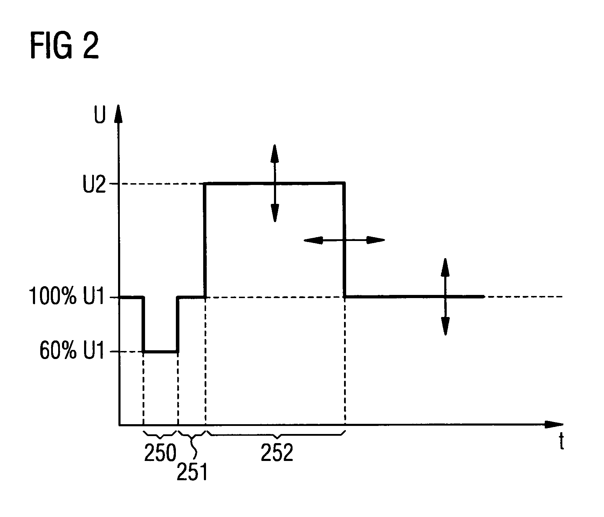

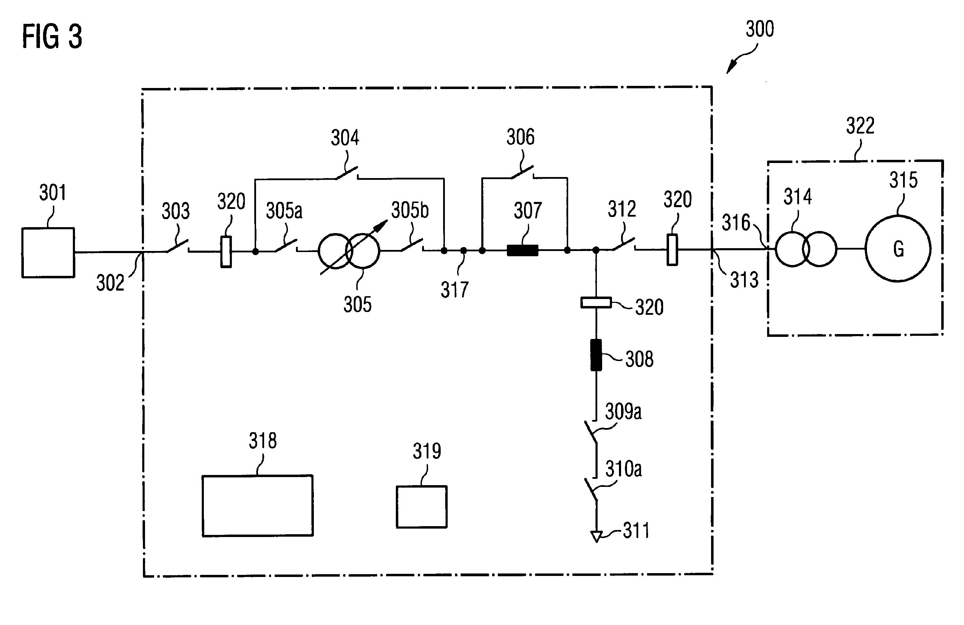

Fig. 2 schematically illustrates a diagram of a voltage course U at the input terminal 113 and 313, respectively, according to an embodiment of performing a method for testing the electric power generation system using the arrangement 100 or 300 for testing an electric power generation system, as illustrated in Fig. 1 or Fig. 3. On an abscissa of the diagram illustrated in Fig. 2 the time t is illustrated, while on an ordinate the voltage U at the input terminal 113 or 313 is illustrated. At time t=0 the voltage U amounts to 100% U1, corresponding to the nominal operation voltage of the utility grid 1 (U1 may also be referred to as first voltage). The situation, when the nominal voltage U1 is applied at the input terminal 113, 313 represents a normal operation of the electric power generation system 114, 115, i.e. a situation or operation when the electric power generation system is not being tested. This operational state may be achieved by closing the switches 103, 104, 106 and 112. At the same time the switches 105a, 105b, 109 and 110 (or 109a and/or 110a, see Fig. 3) are opened.

To subject the electric power generation system 122 (114, 115) to the second voltage U2 at the input terminal 113, 313, the following method steps may be performed:
1. The transformer 105, 305 is adjusted to achieve a desired voltage amplitude increase by for example adjusting a transformation ratio, for example to a factor of 1.4 of the nominal voltage U1. It should be noted that at this point in time the transformer 105 is neither connected to the grid terminal 102 nor connected to the input terminal 113, since the switches 105a and 105b are opened.
2. The electric power generation system 122, 114, 115 (or 322, 314, 315) is not in operation.
3. The impedances 107 and 108 (or coils 107 and 108) are adjusted such that a voltage drop of 0.6 times the nominal voltage U1 would result if these impedances 107, 108 would be connected between the mid point 117 (317) and the reference node or short-cut reference point 111 (311). One should note that in this situation the switch 106 (306) is still closed to bypass the impedance 107 (307) and the switches 109 (309) and 110 (310) are still opened such that actually no voltage drop occurs by a current flow towards the short-cut reference point 111 (311).
4. Switch 106 (306) will be opened so that impedance 107 (307) is not any more bypassed and switches 109 and/or 110 (or alternatively switches 109a and 110a, as illustrated in Fig. 3) will be closed. Thereby, a reduction of the voltage by 40% at the input terminal 113 may be achieved. This situation is illustrated in the time interval 250, as illustrated in Fig. 2, in which the voltage U at the input terminal 113, 313 amounts to about 60% of the nominal voltage U1.
5. After that switch 104 (304) will be opened and the switches 105a and 105b (305a and 305b) will be closed. Thereby, the transformer 105 (305) is connected between the impedance 107 (307) and the grid terminal 102 (302) and the transformer 105 is not bypassed via the switch 104 (304) any more.
6. Thus, the voltage U at the input terminal 113, 313 increases by 40% to again reach 100% of the nominal voltage U1, as is illustrated in the time interval 251 in Fig. 2.
7. At this point the power generation system, here a wind turbine system is started up to reach a working point or a normal operation condition.
8. When the wind turbine system has reached the normal operational state, the switches 309a or 310a are opened (or the switch 109 when the switch 110 was open or the switch 110, when the switch 109 was open) will be opened. Thereby, no voltage drop occurs via the current flow through the impedance 108, 308 so that the voltage U increases.
9. The voltage U at the input terminal 113, 313 increases to the second voltage U2 in the time interval 252, as illustrated in Fig. 2.
10. After having applied the second voltage U2 at the input terminal 113, 313 the electrical response of the power generation system 122, 114, 115 (322, 314, 315) is measured using the measurement systems 119 and 319, respectively, in order to monitor the behavior or reaction of the power generation system upon application of the overvoltage U2.
   After a desired time period of applying the second voltage U2 to the input terminal 113, 313 the switch 310a or 309a will be closed (compare Fig. 3); or the switch 110 will be closed, when switch 109 is opened or 109 will be closed when the switch 110 was opened (compare Fig. 1).
11. Thereby, the voltage U drops from the value U2 back to 100% of the nominal voltage U1 to thus complete the generation and application of the voltage jump.

The lengths of the time intervals 250, 251 and 252 may be appropriately adjusted by correspondingly switching the switches 103, 104, 105a, 105b, 106, 109, 110, 309a, 310a and 112 by controlling these switches using the control system 118 or 318, respectively. Further, the magnitude of the voltage drop from 100% of the nominal voltage to a lower voltage value may be achieved by appropriately selecting and adjusting the impedances 107, 108 or 307 and 308, respectively. Further, the amount of increase from the nominal voltage U1 to the overvoltage U2 may be adjusted by appropriately adjusting a transformation ratio of the transformer 105, 305. Thereby, a great flexibility of designing a voltage course applied at the input terminal 113, 313 is achieved according to an embodiment of the present invention.

Fig. 3 schematically illustrates an arrangement 300 for testing an electric power generation system 314, 315 according to another embodiment. Elements corresponding in structure and/or function to elements illustrated in Fig. 1 are denoted with the same reference signs differing only in the first digit. A number of elements comprised in the test arrangement 300 are similar to elements comprised in the test arrangement 100 illustrated in Fig. 1.

In contrast to the configuration of parallelly arranged switches 109 and 110 connecting the impedance 108 to the reference point or short-cut reference point 111 the impedance 308 is connected via a series arrangement of switches 309a and 310a to the short-cut reference point 311. The arrangement of series connected switches 309a and 310a enables faster switching, in particular if the switches 309a and 310a are mechanical switches. Alternatively or additionally, the switches comprised in the arrangements 100 or 300 may comprise controllable switches, such as transistors.

It should be noted that the term "comprising" does not exclude other elements or steps and "a" or "an" does not exclude a plurality. Also elements described in association with different embodiments may be combined. It should also be noted that reference signs in the claims should not be construed as limiting the scope of the claims.

## Claims

1. Arrangement for testing an electric power generation system, in particular a wind turbine system, being connected to an utility grid providing a predetermined first voltage, the arrangement comprising:
• a input terminal (113, 313) for connecting the arrangement to an output terminal (116, 316) of the power generation system;
• a grid terminal (102, 302) for connecting the arrangement to the utility grid (101, 301);
• a transformer (105, 305) temporarily connectable between the input terminal and the grid terminal, wherein the transformer is adapted to transform the first voltage (U1) to a second voltage (U2) which is different from the first voltage; and
• a measurement system (119, 319) adapted for measuring a current flow through the input terminal; **characterised in that** it further comprises
• a controllable switch (104, 304) connected in parallel to the transformer.

2. Arrangement according to claim 1, wherein the second voltage is greater than the first voltage by an amount between 5% and 100%, in particular between 10% and 70%, further in particular between 30% and 50%, of the first voltage.

3. Arrangement according to claim 1 or 2, wherein the transformer is configured such that a ratio between the first voltage and the second voltage may be variably adjusted, in particular to a ratio between 1:1 and 1:1.5.

4. Arrangement according to one of the preceding claims, wherein the transformer comprises a tapped transformer.

5. Arrangement according to one of the preceding claims, further comprising:
• an electric control system (118, 318) adapted to maintain the second voltage for a predetermined time interval (252) of between 0.1 ms and 1 s, in particular of between 1 ms and 50 ms.

6. Arrangement according to claim 5, wherein the control system comprises a controllable series switch system (105a, 105b, 305a, 305b) connected in series with the transformer between the input terminal and the grid terminal to disconnect the transformer from the utility grid and/or from the input terminal.

7. Arrangement according to one of claims 5 or 6, wherein the control system further comprises a first coil (108, 308) connected between the input terminal and a reference node (111, 311), in particular via at least one reference node switch (109, 110; 109a, 110a).

8. Arrangement according to claim 7, wherein the measurement system is adapted for measuring a current flow at a point between the first coil and the reference node and/or at the grid terminal.

9. Arrangement according to one of claims 5 to 8, wherein the control system further comprises a second coil (107, 307) connected between the input terminal and a mid node (117, 317), wherein the transformer is connected between the mid node and the grid terminal, wherein the control system in particular comprises a switch (106, 306) connected in parallel to the second coil.

10. Arrangement according to one of the preceding claims, wherein the measurement system is further adapted for measuring a voltage between a fixed potential node and the input terminal and/or the grid terminal.

11. Method for testing an electric power generation system, in particular a wind turbine system, being connected to an utility grid, the method comprising:
• connecting the arrangement, via an input terminal (113, 313), to an output terminal (116, 316) of the power generation system (115, 315);
• connecting the arrangement, via a grid terminal (102, 302), to the utility grid providing a predetermined first voltage (U1);
• transforming the first voltage (U1) to a second voltage (U2) which is different from the first voltage using a transformer (105, 305) connected between the input terminal and the grid terminal, and
• measuring a current flow through the input terminal using a measurement system (119, 120, 319, 320), **characterised in that** a controllable switch (104, 304) is connected in parallel to the transformer.

12. Method according to claim 11, wherein the transforming the first voltage to the second voltage comprises:
disconnecting the transformer from the grid terminal;
adjusting a transformation ratio of the transformer for transforming the first voltage to the second voltage;
connecting the utility grid to the input terminal;
reducing a voltage at the input terminal by a current flow via a second coil (107, 307) which is connected between the grid terminal and the input terminal and a first coil (108, 308) which is connected between the input terminal and a reference point (111, 311) towards the reference point;
connecting the transformer to the grid terminal; and
disconnecting the first coil from the reference node.

13. Method according to claim 12, wherein the transforming the first voltage to the second voltage comprises:
applying the first voltage at the input terminal, while the transformer is connected to the grid terminal and while the voltage at the input terminal is reduced by the current flow via the first coil and the second coil towards the reference point; and
applying the second voltage at the input terminal, while the first coil is disconnected from the reference node.

## Patentansprüche

1. Anordnung zur Prüfung eines Stromerzeugungssystems, insbesondere eines Windturbinensystems, das mit einem Versorgungsnetz verbunden ist, welches eine vorgegebene erste Spannung liefert, wobei die Anordnung umfasst:
• eine Eingangsklemme (113, 313) zum Verbinden der Anordnung mit einer Ausgangsklemme (116, 316) des Stromerzeugungssystems;
• eine Netzanschlussklemme (102, 302) zum Verbinden der Anordnung mit dem Versorgungsnetz (101, 301);
• einen Transformator (105, 305), der zeitweilig zwischen die Eingangsklemme und die Netzanschlussklemme schaltbar ist, wobei der Transformator dazu eingerichtet ist, die erste Spannung (U1) in eine zweite Spannung (U2) zu transformieren, welche von der ersten Spannung verschieden ist; und
• ein Messsystem (119, 319), das dazu eingerichtet ist, einen Stromfluss durch die Eingangsklemme zu messen;
**dadurch gekennzeichnet, dass** sie ferner umfasst:
• einen steuerbaren Schalter (104, 304), der zu dem Transformator parallel geschaltet ist.

2. Anordnung nach Anspruch 1, wobei die zweite Spannung um einen Betrag zwischen 5 % und 100 %, insbesondere zwischen 10 % und 70 %, ferner insbesondere zwischen 30 % und 50 % der ersten Spannung größer als die erste Spannung ist.

3. Anordnung nach Anspruch 1 oder 2, wobei der Transformator so eingerichtet ist, dass ein Verhältnis zwischen der ersten Spannung und der zweiten Spannung variabel eingestellt werden kann, insbesondere auf ein Verhältnis zwischen 1:1 und 1:1,5.

4. Anordnung nach einem der vorhergehenden Ansprüche, wobei der Transformator einen Stufentransformator umfasst.

5. Anordnung nach einem der vorhergehenden Ansprüche, welche ferner umfasst:
• ein elektrisches Steuerungssystem (118, 318), welches dazu eingerichtet ist, die zweite Spannung für ein vorgegebenes Zeitintervall (252) von 0,1 ms bis 1 s, insbesondere von 1 ms bis 50 ms, aufrechtzuerhalten.

6. Anordnung nach Anspruch 5, wobei das Steuerungssystem ein steuerbares Serienschaltersystem (105a, 105b, 305a, 305b) umfasst, das mit dem Transformator zwischen der Eingangsklemme und der Netzanschlussklemme in Reihe geschaltet ist, um den Transformator von dem Versorgungsnetz und/oder von der Eingangsklemme zu trennen.

7. Anordnung nach einem der Ansprüche 5 oder 6, wobei das Steuerungssystem ferner eine erste Spule (108, 308) umfasst, die zwischen die Eingangsklemme und einen Referenzknoten (111, 311) geschaltet ist, insbesondere über mindestens einen Referenzknotenschalter (109, 110; 109a, 110a).

8. Anordnung nach Anspruch 7, wobei das Messsystem für das Messen eines Stromflusses an einem Punkt zwischen der ersten Spule und dem Referenzknoten und/oder an der Netzanschlussklemme geeignet ist.

9. Anordnung nach einem der Ansprüche 5 bis 8, wobei das Steuerungssystem ferner eine zweite Spule (107, 307) umfasst, die zwischen die Eingangsklemme und einen mittleren Knoten (117, 317) geschaltet ist, wobei der Transformator zwischen den mittleren Knoten und die Netzanschlussklemme geschaltet ist, wobei das Steuerungssystem insbesondere einen Schalter (106, 306) umfasst, der zu der zweiten Spule parallel geschaltet ist.

10. Anordnung nach einem der vorhergehenden Ansprüche, wobei das Messsystem ferner für das Messen einer Spannung zwischen einem Knoten mit festem Potential und der Eingangsklemme und/oder der Netzanschlussklemme geeignet ist.

11. Verfahren zur Prüfung eines Stromerzeugungssystems, insbesondere eines Windturbinensystems, das mit einem Versorgungsnetz verbunden ist, wobei das Verfahren umfasst:
• Verbinden der Anordnung über eine Eingangsklemme (113, 313) mit einer Ausgangsklemme (116, 316) des Stromerzeugungssystems (115, 315);
• Verbinden der Anordnung über eine Netzanschlussklemme (102, 302) mit dem Versorgungsnetz, welches eine vorgegebene erste Spannung (U1) liefert;
• Transformieren der ersten Spannung (U1) in eine zweite Spannung (U2), welche von der ersten Spannung verschieden ist, unter Verwendung eines Transformators (105, 305), der zwischen die Eingangsklemme und die Netzanschlussklemme geschaltet ist; und
• Messen eines Stromflusses durch die Eingangsklemme unter Verwendung eines Messsystems (119, 120, 319, 320),
**dadurch gekennzeichnet, dass**
ein steuerbarer Schalter (104, 304) zu dem Transformator parallel geschaltet ist.

12. Verfahren nach Anspruch 11, wobei das Transformieren der ersten Spannung in die zweite Spannung umfasst:
Trennen des Transformators von der Netzanschlussklemme;
Einstellen eines Übersetzungsverhältnisses des Transformators zum Transformieren der ersten Spannung in die zweite Spannung;
Verbinden des Versorgungsnetzes mit der Eingangsklemme;
Verringern einer Spannung an der Eingangsklemme durch einen Stromfluss über eine zweite Spule (107, 307), welche zwischen die Netzanschlussklemme und die Eingangsklemme geschaltet ist, und eine erste Spule (108, 308), welche zwischen die Eingangsklemme und einen Referenzpunkt (111, 311) geschaltet ist, in Richtung des Referenzpunktes;
Verbinden des Transformators mit der Netzanschlussklemme; und
Trennen der ersten Spule von dem Referenzknoten.

13. Verfahren nach Anspruch 12, wobei das Transformieren der ersten Spannung in die zweite Spannung umfasst:
Anlegen der ersten Spannung an die Eingangsklemme, während der Transformator mit der Netzanschlussklemme verbunden ist und während die Spannung an der Eingangsklemme durch den Stromfluss über die erste Spule und die zweite Spule in Richtung des Referenzpunktes verringert wird; und
Anlegen der zweiten Spannung an die Eingangsklemme, während die erste Spule von dem Referenzknoten getrennt ist.

## Revendications

1. Agencement pour tester un système de génération d'énergie électrique, en particulier un système d'éolienne, étant connecté à un réseau de service public délivrant une première tension prédéterminée, l'agencement comprenant :
• une borne d'entrée (113, 313) pour connecter l'agencement à une borne de sortie (116, 316) du système de génération d'énergie ;
• une borne de réseau (102, 302) pour connecter l'agencement au réseau de service public (101, 301) ;
• un transformateur (105, 305) temporairement connectable entre la borne d'entrée et la borne de réseau, dans lequel le transformateur est adapté à transformer la première tension (U1) en une deuxième tension (U2) qui est différente de la première tension ; et
• un système de mesure (119, 319) adapté à mesurer un flux de courant à travers la borne d'entrée ;
**caractérisé en ce qu'**il comprend en outre
• un commutateur (104, 304) pouvant être commandé connecté en parallèle au transformateur.

2. Agencement selon la revendication 1, dans lequel la deuxième tension est supérieure à la première tension d'une quantité entre 5% et 100%, en particulier entre 10% et 70%, plus en particulier entre 30% et 50%, de la première tension.

3. Agencement selon la revendication 1 ou 2, dans lequel le transformateur est configuré de telle manière qu'un rapport entre la première tension et la deuxième tension peut être ajusté de façon variable, en particulier à un rapport entre 1:1 et 1:1,5.

4. Agencement selon l'une des revendications précédentes, dans lequel le transformateur comprend un transformateur à prises.

5. Agencement selon l'une des revendications précédentes, comprenant en outre :
• un système de commande (118, 318) électrique adapté à maintenir la deuxième tension pendant un intervalle de temps (252) prédéterminé d'entre 0,1 ms et 1 s, en particulier d'entre 1 ms et 50 ms.

6. Agencement selon la revendication 5, dans lequel le système de commande comprend un système de commutateurs en série (105a, 105b, 305a, 305b) pouvant être commandés connectés en série avec le transformateur entre la borne d'entrée et la borne de réseau pour déconnecter le transformateur du réseau de service public et/ou de la borne d'entrée.

7. Agencement selon l'une des revendications 5 ou 6, dans lequel le système de commande comprend en outre une première bobine (108, 308) connectée entre la borne d'entrée et un noeud de référence (111, 311), en particulier par l'intermédiaire d'au moins un commutateur (109, 110 ; 109a, 110a) de noeud de référence.

8. Agencement selon la revendication 7, dans lequel le système de mesure est adapté à mesurer un flux de courant en un point entre la première bobine et le noeud de référence et/ou à la borne de réseau.

9. Agencement selon l'une des revendications 5 à 8, dans lequel le système de commande comprend en outre une deuxième bobine (107, 307) connectée entre la borne d'entrée et un noeud médian (117, 317), dans lequel le transformateur est connecté entre le noeud médian et la borne de réseau, dans lequel le système de commande comprend en particulier un commutateur (106, 306) connecté en parallèle à la deuxième bobine.

10. Agencement selon l'une des revendications précédentes, dans lequel le système de mesure est en outre adapté à mesurer une tension entre un noeud à potentiel fixe et la borne d'entrée et/ou la borne de réseau.

11. Procédé de test d'un système de génération d'énergie électrique, en particulier un système d'éolienne, étant connecté à un réseau de service public, le procédé comprenant :
• la connexion de l'agencement, par l'intermédiaire d'une borne d'entrée (113, 313), à une borne de sortie (116, 316) du système de génération d'énergie (115, 315) ;
• la connexion de l'agencement, par l'intermédiaire d'une borne de réseau (102, 302) au réseau de service public délivrant une première tension (U1) prédéterminée ;
• la transformation de la première tension (U1) en une deuxième tension (U2) qui est différente de la première tension en utilisant un transformateur (105, 305) connecté entre la borne d'entrée et la borne de réseau, et
• la mesure d'un flux de courant à travers la borne d'entrée en utilisant un système de mesure (119, 120, 319, 320),
**caractérisé en ce qu'**un commutateur (104, 304) pouvant être commandé est connecté en parallèle au transformateur.

12. Procédé selon la revendication 11, dans lequel la transformation de la première tension en la deuxième tension comprend :
la déconnexion du transformateur de la borne de réseau ;
l'ajustement d'un rapport de transformation du transformateur pour transformer la première tension en la deuxième tension ;
la connexion du réseau de service public à la borne d'entrée ;
la réduction d'une tension au niveau de la borne d'entrée par un flux de courant par l'intermédiaire d'une deuxième bobine (107, 307) qui est connectée entre la borne de réseau et la borne d'entrée et d'une première bobine (108, 308) qui est connectée entre la borne d'entrée et un point de référence (111, 311) vers le point de référence ;
la connexion du transformateur à la borne de réseau ; et
la déconnexion de la première bobine du noeud de référence.

13. Procédé selon la revendication 12, dans lequel la transformation de la première tension en la deuxième tension comprend :
l'application de la première tension à la borne d'entrée, tandis que le transformateur est connecté à la borne de réseau et tandis que la tension au niveau de la borne d'entrée est réduite par le flux de courant par l'intermédiaire de la première bobine et de la deuxième bobine vers le point de référence ; et
l'application de la deuxième tension à la borne d'entrée, tandis que la première bobine est déconnectée du noeud de référence.
